# EUROPEAN PATENT APPLICATION

(11) **EP 4 617 411 A1**
(43) Date of publication of application: **17.09.2025**
(21) Application number: 25163166.9
(22) Date of filing: 12.03.2025
(51) Int. Cl.: C30B 25/08, C30B 29/36

(54) **MONOCRYSTALLINE COATINGS FOR REACTOR PARTS SUITABLE FOR THE EPITAXIAL DEPOSITION OF SEMICONDUCTOR FILMS**

(30) Priority: 15.03.2024 IT 202400005800
(71) Applicant: LPE S.p.A., 20021 Baranzate (MI) (IT)
(72) Inventor: PRETI, Silvio Roberto Mario, Baranzate (MI) (IT); VECCHIO, Carmelo, Catania (IT); MESCHIA, Maurilio Giuseppe, Asti (IT); MESSINA, Cristian, San Giovanni la Punta (CT) (IT)
(74) Representative: Buzzi, Notaro & Antonielli d'Oulx S.p.A.

(57) **Abstract**

The present invention relates to a deposition unit of a reactor for the epitaxial deposition of semiconductor films on a substrate, wherein selected internal parts of said unit are provided with one or more layers of a monocrystalline, chemically inert material suitable to operate at temperatures up to 1700°C and adapted to inhibit dendritic parasitic growth of semiconductor agglomerates on said internal parts. The present invention also relates to an epitaxial reactor comprising one or more deposition units as hereinbefore described.

## Description

### FIELD OF INVENTION

The present invention relates to the field of epitaxial deposition of semiconductor films on substrates; in particular to a deposition unit adapted to reduce preventive maintenance times.

Additionally, though not exclusively, the present invention relates to the field of the deposition of silicon carbide films on a semiconductor substrate in a hot-wall, crossflow homoepitaxial or heteroepitaxial reactor.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface features, making them suitable for the manufacturing of highly complex microprocessors and memory devices.

Typically, the reaction chamber is heated to a desired temperature before film deposition, and then the temperature is maintained substantially constant throughout the deposition process.

In case of epitaxial reactors for the deposition of silicon carbide, the temperatures reached within the cavity of the chamber may be in the 1500-1700 °C range. These temperatures may be reached in many ways, and the chamber may be of the "hot-wall" or "cool-wall" type. In the former non-limiting example, the walls of the reaction chamber, as well as the enclosed cavity, reach high deposition temperatures. In this case, the reaction chamber may comprise one or more graphite partition elements, which may be effectively heated to the desired temperatures via induction means. The reaction chamber may additionally comprise other graphite functional parts, such as graphite substrate holders, rings, and upstream and downstream elements.

During an epitaxial deposition process, a semiconductor film grows in a controlled fashion on a substrate. However, the semiconductor may also grow on other areas of the reaction chamber. For example, in case of a reactor for the deposition of monocrystalline silicon carbide, such as its 4H- and 6H- polytypes, uncontrolled polycrystalline silicon carbide build-up has been observed to occur on the partition elements and the functional parts of the chamber. It is noted that this undesired silicon carbide build-up is very difficult to remove, its hardness being comparable to that of diamond.

The above parasitic phenomenon is particularly relevant in hot-wall reactors, where it is especially impacting the upstream end of the chamber (i.e. where the precursor gases enter the reaction chamber), as well as the elements in proximity or in contact with the substrate. These may be made, in toto or in part, of graphite, and coated in TaC or poly-SiC.

It has been observed that these parasitic depositions often result in the rapid growth of cauliflower-like, porous, dendritic structures, which eventually affect the quality of deposited films.

In order to prevent these side effects, the reaction chamber is subject to frequent Preventive Maintenance (PM) operations, for instance after every 300 to 3000 µm, preferably 500 to 700 µm of film growth. During PM, the machine is cooled and purged, and some or all affected parts are manually removed from the chamber for cleaning/disposal and substitution. PM operations affect the productivity of the reactor and negatively impact on the economics of the epitaxial deposition process, as they may cause up to 8-12 hours of reactor downtime.

It is noted that undesired SiC buildup does not occur only on bare graphite surfaces of the reaction chamber but also on those parts that are preventively coated with TaC or SiC.

Indeed, some or all parts of the reaction chamber are typically coated with a TaC layer to protect the graphite surfaces during cleaning operations. Alternatively, a thin layer of SiC, is used to seal the exposed porous graphite surfaces to avoid contamination. In this case, SiC is always used in its polycrystalline form, because it can be easily deposited and is cost effective.

The issue of parasitic deposition is not particular to epitaxial reactors but may also occur in physical vapor transport systems for substrate manufacturing, also known as sublimators.

WO2007088420 addresses the issue of undesired material depositing on the walls of a reaction chamber during epitaxial growth processes at high temperatures. The application discloses a new approach based on differentiating the temperatures of the reaction chamber walls, by modifying the geometry of the reaction cavity. In this case, however, it is difficult to identify the correct design to balance competing interests (quality of deposition, speed, and lower parasitic build-up), since temperature and temperature gradients in the cavity of the reaction chamber play a critical role in the deposition process.

In conclusion it is desirable to provide a new reaction chamber for silicon carbide deposition adapted to reduce the frequency of PM operations and ensure high quality film deposition. It is furthermore desirable to hinder or reduce parasitic SiC growth on the walls and other elements of the reaction chamber. Additionally, it would be advantageous to provide a new epitaxial reactor incorporating the aforementioned reaction chamber. It would furthermore be desirable to have a SiC physical vapor transport system with reduced parasitic SiC growth.

### SUMMARY OF THE DISCLOSURE

It is an object of the present invention to overcome the disadvantages of the prior art. In particular, it is an object of the present invention to provide a deposition unit for reducing the frequency of PM operations, in particular, but not exclusively, when used in a hot-wall reactor for the epitaxial deposition of SiC films on semiconductor substrates of same or different materials. It is a further object of the present invention to provide a deposition unit adapted to hinder the parasitic growth of poly-SiC.

Under a second aspect, it is an object of the present invention to provide a new reactor suitable to incorporate the deposition unit hereinbefore described.

Under a third aspect it is an object of the present invention to provide a physical vapor transport system for the production of silicon carbide substrates.

The main objectives described above are achieved through the invention recited in the appended claims, which constitute an integral part of the present description. The use of reference signs in the claims does not limit their scope. The sole purpose of reference signs is to make the claims easier to understand.

This summary is provided to introduce a selection of concepts in a simplified form. These concepts are further described in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE FIGURE

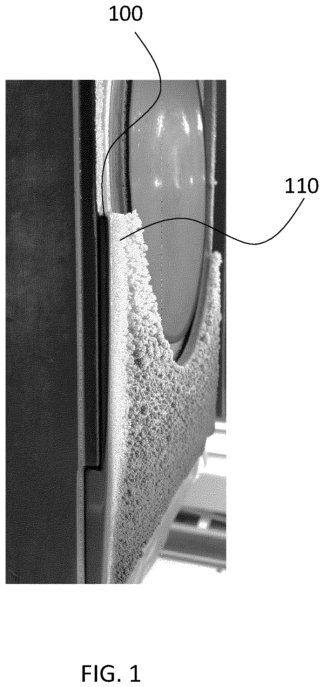

FIG. 1 is a picture of a reaction chamber part exhibiting parasitic deposits.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

In general, the present invention is based on the observation that parasitic growth in a deposition unit for the epitaxial deposition of a semiconductor film on a substrate is hindered if the internal parts exposed to a flow of precursor gases are covered with at least one layer of monocrystalline material. The material should be carbon-based, chemically inert at a temperature up to 1700°C, and having a melting point above 1700 °C.

Typically, the precursor gases include Si and C precursors. For example, the silicon precursor gas may be a chlorinated compound, preferably dichlorosilane, trichlorosilane or tetrachlorosilane. The carbon precursor gas may be a hydrocarbon, in particular propane, ethylene, acetylene, or methane. Other types of precursors may be used.

Other precursors, such as for n- and p- doping may flow in the deposition unit of a reactor. For instance, the n-source may be nitrogen, acetonitrile, pyrrole, ammonia, hydrazine, hydrogen cyanide, methylamine.

Other gases may flow into the deposition unit, for example purging, cooling, and carrier gases. Example of suitable gases include hydrogen, argon and neon.

Typically, the pressure inside the deposition unit during deposition process is around 50-200 mbar. Otherwise, the deposition unit is at ambient pressure (~1 bar).

Advantageously the monocrystalline material may be chosen to be inert to precursor gases at temperature up to 1700°C, and advantageously also at pressures of 50-200 mbar.

In particular, the monocrystalline material may be monocrystalline diamond or mono-SiC, which have been observed to work particularly well in the field of epitaxial SiC deposition and satisfy the requirements of being (i) carbon-based, (ii) chemically inert at a temperature up to 1700°C, and(iii) having a melting point above 1700 °C. The internal parts may be made of graphite and may be suitably covered with the monocrystalline material described above. Advantageously the internal parts may be spare parts of SiC reactors, such as substrate holders, centering rings, and/or upstream and downstream covers (upstream and downstream in respect to a flow of precursor gases).

The present invention is therefore directed to a graphite element, which is a SiC reactor spare part, coated with the monocrystalline material hereinbefore described, and suitable to be used in the deposition unit set out below.

Under one aspect, the present invention relates to a deposition unit for an epitaxial reactor suitable for the deposition of a semiconductor film on a substrate and configured to receive a flow of precursor gases.

The deposition unit comprises: (i) at least one partition element provided with a receiving area adapted to receive a substrate holder; and (ii) at least one graphite element featuring at last one coated surface exposed to the flow of precursor gases.

The coated surface is a surface covered or coated with at least one coat, i.e. a layer, of a monocrystalline material having a melting point above 1700 °C. Furthermore, the monocrystalline material is carbon-based and chemically inert at a temperature up to 1700°C.

It is understood that additional coatings may be applied below or above the layer of monocrystalline material without departing from the scope of the invention.

With the expression "deposition unit" it is meant the enclosure where the epitaxial reaction and deposition process takes place, and includes the internal cavity defined by said enclosure. The deposition unit may coincide with the reaction chamber or be a sub-assembly thereof.

The deposition unit according to the invention may be advantageously employed in the epitaxial or homoepitaxial deposition of silicon carbide films on a semiconductor substrate. In particular, it may be satisfactorily used in an epitaxial reactor featuring a crossflow, horizontal and/or hot-wall configuration. Indeed, in these types of reactors, the issue of parasitic deposition is particularly felt. Furthermore, in the case of SiC reactors, the hardness of the material makes it particularly difficult to remove any undesired build-up, and the cleaning process may end up damaging the parts concerned.

The deposition unit according to the invention may comprise one or more partition elements, such as walls, to create an enclosure. In case of induction heating of the deposition unit, one or more partition elements may be advantageously made of graphite.

The deposition unit is configured to receive a flow of precursor gases, i.e. it may comprise any suitable injection system, such as any adaptation to the deposition unit that allows injecting one or more precursors within its cavity, and to direct their flow towards a substrate on a substrate holder, when the latter is placed in the receiving area. For example, the injection system may comprise one or more inlets, nozzles, or shower heads.

It is noted that the layer of monocrystalline material may cover the coated surface of at least one graphite element in one piece.

Alternatively, the layer of monocrystalline material may be composed of a plurality of tiles disposed over and coating the exposed surface of the graphite element. With the term "tile" it is meant a macroscopic piece of material.

The deposition unit will likely also be configured to discharge exhaust gases, for example via one or more outlets.

The deposition unit may additionally comprise other structural elements used to increase its heating efficiency, such as further graphite parts or enclosures.

The deposition unit according to the present invention may also comprise a thermally insulating system, made of one or more casings of a thermally insulating material. To this effect, porous carbonaceous materials can be used, for instance carbon composites made from short cut carbon fibers, optionally interconnected in a matrix, or pressed together.

The advantage of using the monocrystalline material hereinbefore described is twofold. First, the material is capable to withstand the operating conditions of the deposition unit, without interfering with the reaction and deposition process.

Second, using one or more layers of monocrystalline material to coat the graphite surfaces of the deposition unit may produce an advantageous effect. In case of a bare graphite surface, or a surface coated with poly-TaC or poly-SiC, parasitic semiconductor growth happens in an uncontrolled dendritic fashion, as shown in FIG. 1, where the graphite reactor parts 100, are affected by rough parasitic deposits 110. Conversely, if one or more layers of monocrystalline material are used to cover the graphite surfaces exposed to precursor gases, they will foster an ordered heteroepitaxial or homoepitaxial growth, depending on the material used. This heteroepitaxial growth rate would be the relevant growth rate to monitor and will require less frequent PM operations than an uncontrolled dendritic growth. It is noted that in the art, the graphite elements of the deposition unit are generally coated, either to protect the element during cleaning, or to "seal" the exposed porous graphite surface and avoid contamination.

Under a first embodiment, the monocrystalline material used for the coated surface in the deposition unit according to the invention is monocrystalline diamond or monocrystalline SiC. Both materials are characterized by a controlled crystalline structure and are advantageously capable to withstand the operating temperatures of the deposition unit, without melting or sublimating. Therefore, they may effectively coat the surface of the graphite element during reactor operation. Additionally, thanks to their specific inert, carbon-based composition, the materials selected above do not interfere with the deposition process or contaminate the deposition unit.

It is noted that polycrystalline SiC would not work well in the execution of the invention. Indeed, the growth rate of porous poly-SiC is considerably higher than that of mono-SiC under identical growth conditions. Indeed, the inventors have observed that poly-SiC build up increases in height following an exponential curve during 3-4 days of reactor operation, while mono-SiC follows a linear behavior in the same time frame and under identical operating conditions. Additionally, the effective growth rate of the porous parasitic layer increases with increasing thickness due to the tendency of growth occurring preferentially at edges, tips, and at ends of other protruding shapes.

It has been observed that the use poly-SiC coatings to shield graphite parts is not successful in inhibiting parasitic growth, considering that in case of SiC deposition, the epitaxy substrate is necessarily formed of monocrystalline SiC.

This leads to a considerable discrepancy between the growth rates on the graphite elements of the deposition unit (such as consumable parts or partitions) versus the substrate. By modifying the exposed surfaces so that they are covered by mono-SiC (instead of poly-SiC, TaC or being left bare), the discrepancy may be evened out, and the maximum epitaxial growth between PM steps may be advantageously and significantly increased. Since the parasitic deposition of SiC is more rapid in the upstream end of the deposition unit, it may be preferable to use mono-SiC parts especially in correspondence to the upstream section of said unit.

It is additionally noted that polycrystalline diamond would not work well in the execution of the invention. Indeed, because of its non-uniform crystal structure, uncontrolled parasitic growth may still occur on this type of material.

However, the use of one or more monocrystalline diamond layers may provide several advantages. In this case, the relevant growth rate would be the heteroepitaxial growth rate of SiC on diamond which is expected to be much lower than the growth of SiC on poly-SiC and bare graphite. Therefore, also in case of monocrystalline diamond, PM operations may be spaced out, resulting in an advantageous reduction of the overall reactor downtime.

In case of a SiC reactor, using monocrystalline cover layers other than SiC could have the benefit of being chemically distinct from the parasitic SiC deposits. Any chemical differences could be exploited for developing selective in-situ and/or ex-situ cleaning methods for the deposition unit and its parts. For example, in case of ex-situ wet cleaning, one could develop chemistries that preferentially remove poly-SiC without considerably attacking the layer of different monocrystalline material underneath.

The one or more monocrystalline diamond layers hereinbefore described may be obtained by applying one or more tiles of commercial, synthetic, monocrystalline diamond on the surfaces to be coated. The tiles may be suitably cut to continuously cover the surfaces of interest, for example via laser machining.

In case mono-SiC is selected as the monocrystalline material to layer on the graphite elements, it is possible use monocrystalline SiC wafers suitably shaped in one or more pieces, for example by cutting a monocrystalline SiC substrate via laser-machining. The mono-SiC pieces thus obtained can be arranged onto the surfaces most concerned by the parasitic growth.

Although larger mono-SiC cover pieces could be beneficial from a cleanliness point of view, one could also utilize smaller pieces to reduce the need for high-cost larger-diameter SiC wafers as starting materials and/or to reduce waste.

It is noted that one or more monocrystalline non-SiC materials may be used in conjunction with mono-SiC materials for covering the walls of a process chamber.

The inventors have observed that using the 4H-SiC or 6H-SiC polytype as the monocrystalline material of choice works particularly well in the execution of the invention. Indeed, in case of a deposition unit for epitaxial SiC deposition, the mono-SiC film being deposited is the 4H-SiC or the 6H-SiC polytype. By matching the crystalline structure of the monocrystalline material layer of the graphite element and of the film deposited on the substrate, a particularly compact, regular growth is observed to build up on the layer of monocrystalline material.

Under another embodiment, in the deposition unit according to the present invention, the graphite elements may be a removable part, such as a spare or consumable component of the deposition unit adapted to be removed therefrom. As a nonlimiting example, removable parts may include substrate centering rings, substrate holders, upstream and/or downstream covers, etc.

In addition, or in alternative to the embodiment recited above, at least one graphite element may be a partition element. For example, it may be the bottom wall of the deposition unit exposed to the flow of precursor gases, or parts thereof.

Under a different aspect, the present invention relates to an epitaxial reactor for the deposition of a semiconductor film on a substrate, comprising: (i) at least one deposition unit according to any one of the preceding claims; (ii) an induction system for heating the at least one deposition unit; and (iii) a gas management system for delivering precursor gases to the at least one deposition unit.

It is understood that the reactor according to the invention may include other elements required for its operation, in accordance with standard practice. For example, it may comprise an enclosure optionally made of quartz and preferably cooled with a cooling fluid such as water. The deposition unit may be inserted in said enclosure, and both may be surrounded by the induction system.

Preferably, the epitaxial reactor according to the invention is adapted to receive the flow of precursor gases in a crossflow configuration and is adapted for the deposition of silicon carbide. Even more preferably, the epitaxial reactor according to the invention is a hot-wall reactor.

Under another aspect, the present invention relates to a physical vapor transport system comprising the deposition unit hereinbefore described.

For instance, the physical vapor transport system to produce silicon carbide according to the invention may comprise an enclosure and at least one graphite element contained within said enclosure. The graphite element features at last one coated surface exposed to a flow of sublimated silicon carbide, comprising at least one layer of a monocrystalline material. The monocrystalline material is carbon-based, chemically inert at a temperature up to 1700°C, and features a melting point above 1700 °C.

The subject matter of the present disclosure includes all novel and nonobvious combinations and sub-combinations of the various processes, systems, and configurations, and other features, functions, acts, and/or properties disclosed herein, as well as any and all equivalents thereof.

In the description and the claims in this application the words "comprise" and its variations such as "comprising" and "comprises" do not rule out the presence of other additional elements, components, or stages.

The discussion of documents, deeds, materials, apparatus, articles and the like is included in the text solely for the purpose of providing context for this invention; it should not however be understood that this material or part thereof constitutes general knowledge in the field relating to the invention prior to the priority date of each of the claims appended to this application.

## Claims

1. A deposition unit for an epitaxial reactor for the deposition of a semiconductor film on a substrate and configured to receive a flow of precursor gases; said deposition unit comprising:
- at least one partition element provided with a receiving area, said receiving area being adapted to receive a substrate holder;
- at least one graphite element featuring at last one coated surface exposed to the flow of precursor gases;
wherein said coated surface comprises at least one layer of a monocrystalline material; said monocrystalline material being carbon-based, chemically inert at a temperature up to 1700°C, and featuring a melting point above 1700 °C.

2. The deposition unit according to claim 1, wherein the monocrystalline material is monocrystalline diamond and/or monocrystalline SiC.

3. The deposition unit according to claim 2, wherein the monocrystalline SiC material is a 4H-SiC or 6H-SiC polytype.

4. The deposition unit according to any one of claims 1-3, wherein the at least one graphite element is a removable part.

5. The deposition unit according to claim 4, wherein the at least one graphite element is the at least one partition element.

6. The deposition unit according to any one of the preceding claims, wherein the at least one layer of monocrystalline material covers the coated surface of at least one graphite element in one piece.

7. The deposition unit according to any one of claims 1-5, wherein the at least one layer of monocrystalline material comprises a plurality of tiles.

8. An epitaxial reactor for the deposition of a semiconductor film on a substrate, comprising:
- At least one deposition unit according to any one of the preceding claims;
- an induction system for heating the at least one deposition unit;
- a gas management system for delivering precursor gases to the at least one deposition unit.

9. The epitaxial reactor according to claim 8, wherein the deposition unit is adapted to receive the flow of SiC precursor gases in a crossflow configuration.

10. A physical vapor transport system for the production of silicon carbide comprising an enclosure and at least one graphite element contained within said enclosure; wherein said graphite element features at last one coated surface exposed to a flow of sublimated silicon carbide; said coated surface comprising at least one layer of a monocrystalline material; said monocrystalline material being carbon-based, chemically inert at a temperature up to 1700°C, and featuring a melting point above 1700 °C.

11. A graphite element suitable for a deposition unit of an epitaxial reactor, wherein said graphite element is a substrate holder, a centering ring, an upstream cover, or a downstream cover featuring at last one coated surface exposed to a flow of precursor gases; wherein said coated surface comprises at least one layer of a monocrystalline material; said monocrystalline material being carbon-based, chemically inert at a temperature up to 1700°C, and featuring a melting point above 1700 °C.
